# EUROPEAN PATENT SPECIFICATION

(11) **EP 2 613 461 B1**
(45) Date of publication and mention of the grant of the patent: **07.03.2018**
(21) Application number: 12305004.9
(22) Date of filing: 03.01.2012
(51) Int. Cl.: H04B 10/572, H01S 5/14, H01S 3/08, H01S 5/026, H01S 5/40

(54) **Optical transmitter for WDM optical network**
Optischer Sender für ein optisches WDM-Netzwerk
Transmetteur optique pour réseau optique WDM

(43) Date of publication of application: 10.07.2013
(73) Proprietor: ALCATEL LUCENT, 92100 Boulogne-Billancourt (FR)
(72) Inventor: Galli, Paola, 25030 Adro (BS) (IT); Iachelini, Alessandro, 22036 Erba (Como) (IT); Di Mola, Domenico, 20045 Besana Brianza (MB) (IT)
(74) Representative: Nokia Bell Patent Attorneys

(56) References cited:
- EP-A1- 0 688 114
- US-A1- 2010 034 224
- US-A1- 2010 316 378
- US-A1- 2011 129 227

## Description

### Field of the invention

The invention relates to the field of optical networks. The present invention relates to an optical transmitter, in particular (but not exclusively) for a WDM (Wavelength Division Multiplexing) optical network, and to a WDM optical comprising such an optical transmitter. The optical network is preferably an optical access network.

### Background

As it is known, a passive optical network (PON) is a type of an optical access network, i.e. a network allowing a plurality of users to be connected to a node of a core network (for instance, a metropolitan area network).

A PON typically comprises an optical line termination (OLT) and an optical distribution network (ODN). The ODN in turn comprises a plurality of optical links (typically comprising silica-based single-mode optical fibers) and passive optical components arranged so as to form a point-multipoint structure whose root is connected to the OLT. The OLT is typically located at a central office (CO) of the service provider. Each optical link of the OLT may be terminated at its far end by a respective optical network unit (ONU). Depending on the applications, an ONU may be located within the user's home (FTTH - Fiber To The Home), at the basement of a building (FTTB - Fiber To The Building) or at the curb in the proximity of one or more buildings (FTTC - Fiber To The Curb).

In a WDM PON, each ONU may communicate with the OLT by using a respective couple of wavelengths, comprising an upstream wavelength, which the ONU uses for transmission to the OLT, and a downstream wavelength, which the OLT uses for transmission to the ONU. The upstream wavelengths may be for instance located in the so-called C band, preferably in the range of 1530 nm to 1565 nm, whereas the downstream wavelengths may be for instance located in the so-called L band, preferably in the range of > 1565 nm.

In a WDM PON, the ODN typically comprises a so-called "remote node", a feeder optical fiber connecting the remote node to the OLT and a number of distribution optical fibers radiating from the remote node. Each distribution fiber may be terminated at its far end by an ONU or by a power splitter connecting the distribution fiber with multiple ONUs via multiple drop optical fibers.

The feeder fiber has a length typically ranging from about 5 km to about 40 km. The distribution fibers typically have a length ranging from some tens of meters to a few kilometers, depending on the environment - metropolitan or rural - and on the application. The remote node is typically a passive node, which means that it comprises only passive components such as Arrayed Waveguide Gratings (AWG) or optical couplers, which do not need power supply.

In the downstream direction, the OLT generates downstream optical signals at the downstream wavelengths associated to the ONUs, multiplexes them according to the known WDM technique and transmits them to the remote node along the feeder fiber. At the remote node, the downstream signals may be demultiplexed and each of them may then be forwarded to a respective ONU along a respective distribution fiber.

In the upstream direction, each ONU generates a respective upstream signal at the upstream wavelength associated thereto and transmits it along the respective distribution fiber to the remote node. The remote node multiplexes all the upstream signals received from the various ONUs according to the known WDM technique, and forwards them to the OLT through the feeder fiber. At the OLT, the upstream signals are de-multiplexed and subjected to subsequent processing.

Thus, each ONU should comprise a transmitter capable of transmitting at the upstream wavelength assigned thereto. To minimize both manufacturing and inventory costs of the ONUs, it is known providing all the ONUs with a same type of transmitter which is "colorless", i.e. which in principle may transmit optical signals over a wide range of wavelengths, and that may be optically tuned by on the proper upstream wavelength assigned to the ONU.

The document US 2010/0034224 A1 discloses a laser module, which uses two periodic filters placed within a series arrangement of two mirrors and an optical amplifier for selecting an oscillating wavelength.

The document EP 0 688 114 A1 discloses a WDM transmission system for an optical access network, wherein a transmission module contains a set of optical amplifiers placed between two mirrors and a waveguide grating router placed between the optical amplifiers and one of the mirrors.

The document US 2010/0316378 A1 discloses a WDM laser module in which a set of laser devices is coupled to a cyclic waveguide structure with separate ports at its output, wherein to one of the ports a mirror is coupled.

### Summary

Proposed is an optical transmitter for an optical network. The optical transmitter comprises a first mirror and a second mirror, a semiconductor optical amplifier as well as a first optical filter and a second optical filter. The first optical filter and the second optical filter are in series connection to each other. The first mirror is located, such that a first fraction of an optical signal emitted by the semiconductor optical amplifier is reflected back to the semiconductor optical amplifier. A second fraction of an optical signal emitted by the semiconductor optical amplifier is transmitted towards the series connection of the optical filters.

The first optical filter is a cyclic Arrayed Waveguide Grating (AWG) containing a number of amplifier-sided ports to which respective semiconductor optical amplifiers may be connected. The second optical filter is a non-cyclic AWG containing a number of incoming ports. The SOA is connected indirectly via said first filter to a port of the second optical filter. The second mirror is optically coupled to the first or the second filter, such that the first and the second mirror delimit a cavity, which comprises the semiconductor optical amplifier and at least one of the optical filters and which is adapted to generate a coherent optical signal.

The proposed optical transmitter has the advantage, that the optical wavelength emitted by the optical transmitter is determined by the passband characteristics of the two optical filters. Thus, the emitted optical wavelength can be tuned by the choice of the ports of the optical filters.

### Brief description of the Figures

Figure 1 shows an optical access network.
Figure 2 shows different transmission bands for upstream and downstream signals.
Figure 3 shows a first embodiment of a proposed optical line terminal.
Figure 4 shows an embodiment of a first optical filter.
Figure 5 shows different spectra as well as pass-bands for downstream signals in a mode of operation of the proposed optical line terminal.
Figure 6 shows an optical line terminal according to a further solution.
Figure 7 shows an optical line terminal according to an even further solution.
Figure 8 shows an optical line terminal according to another even further solution.
Figure 9 shows a first embodiment of a proposed optical network unit.
Figure 10 shows different spectra as well as pass-bands for upstream signals in a mode of operation of the proposed optical network unit.
Figure 11 shows an alternative solution of the proposed optical network unit.
Figure 12 shows different spectra as well as bass-bands for downstream signals in a mode of operation of the proposed optical network unit.
Figure 13 shows a second embodiment of a post-optical network unit.
Figure 14 shows an alternative solution of the proposed optical network unit according to the second embodiment.

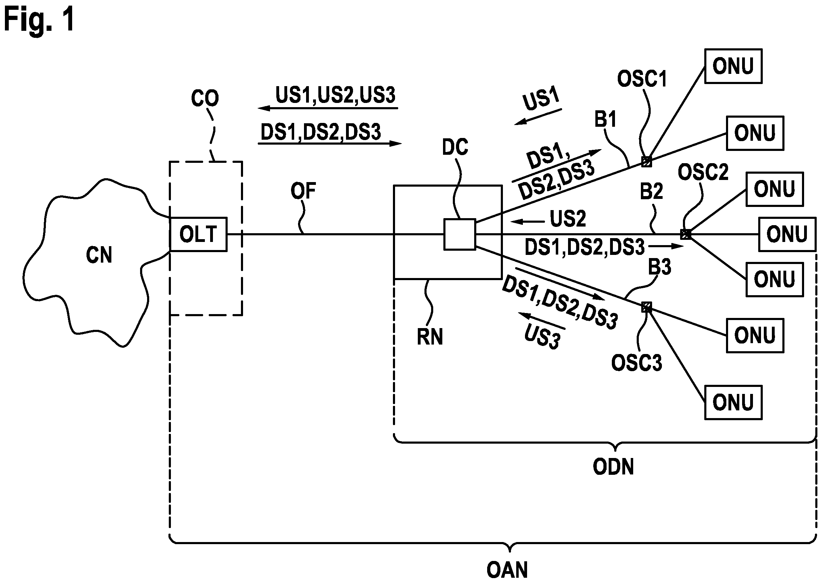

Figure 1 shows an optical access network OAN, which is connected at a central office CO via an optical line terminals (OLT) to a core network CN.

The OLT is connected via an optical feeder fibre OF to a remote note RN. Downstream signals DS1, DS2, DS3 are transmitted at respective downstream wavelengths to the remote note RN.

The branches B1, B2, B3 themselves may contain further splitting units OSC1, OSC2, OSC3 for furthermore splitting the downstream signals DS. At the end of the optical branches B1, B2, B3, customer sided access network termination units in the form of optical network units ONU are connected, which are alternatively optical network terminals (ONT). Distribution of the downstream signals DS1, DS2, DS3 is performed by the optical splitting unit OSC, by splitting the downstream signals DS1, DS2, DS3 onto the branches B1, B2, B3. The optical splitting units OSC1, ..., OSC3 may split the downstream signals by means of power splitting, such that each of the downstream signals DS1, DS2, DS3 is split onto each of the branches B1, B2, B3.

Each downstream signal DS1, DS2, DS3 of a specific wavelength carries one or more data signals that are assigned to one or more ONUs. Therefore, each ONU is assigned a specific downstream wavelength. The remote note RN receives the downstream signals DS1, DS2, DS3 and distributes them onto the optical branches B1, B2, B3 that are connected to the remote note RN.

According to a first solution, shown in the Figure 1, the remote nodes contains as an optical splitting unit OSC a power splitter, which splits the power of all downstream signals DS1, DS2, DS3 with all wavelengths onto all branches B1, B2, B3 that are connected to the remote note RN. According to this first solution, all ONUs receive all downstream signals at all downstream wavelengths.

According to a second solution, not shown explicitly in Figure 1, the remote node contains as an optical splitting unit OSC an optical filter in the form of an optical wavelength multiplexer/demultiplexer, which splits the downstream signals DS1, DS2, DS3 such that a specific downstream signal with a specific wavelength that carries data signals assigned to one or more specific ONUs is provided only onto the specific branch of these specific ONUs. The optical wavelength multiplexer/demultiplexer is preferably an AWG. According to this second solution, an ONU receives a downstream signal only at that downstream wavelength which is assigned to this ONU.

The ONUs transmit upstream signals US1, US2, US3 at respective upstream wavelengths that are assigned to the ONUs. These upstream signals US1, US2, US3 are combined by the optical splitting units OSC, OSC1, OSC2, OSC3 and then transmitted over the optical feeder fibre OF to the line terminal OLT.

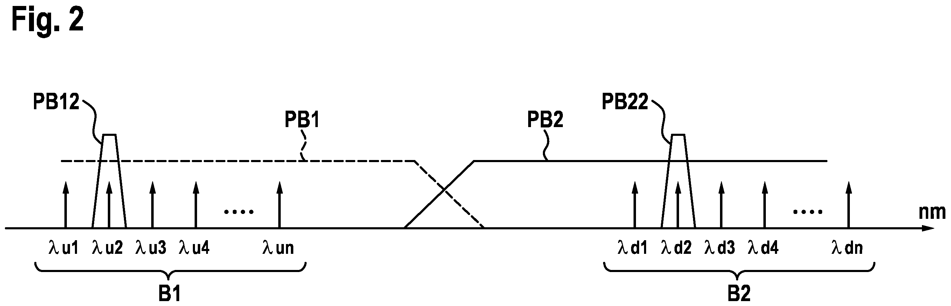

Figure 2 shows an example of upstream wavelengths λu1, λu2, ... λun that are comprised in a first waveband B1, whereas the downstream wavelengths λd1, λd2, .... λdn are comprised in a second waveband B2. The first waveband B1 and the second waveband B2 do not overlap. Preferably, the first waveband B1 is the C band, whereas the second waveband is the L band. Adjacent downstream wavelengths λd1, λd2, .... λdn and adjacent upstream wavelengths λu1, λu2, .... λun are preferably spaced by a same channel spacing (for instance, about 0.8 nm).

Coming back to Figure 1, for transmitting downstream signals DS1, DS2, DS3 at respective downstream wavelengths from the OLT to the ONUs, the OLT needs to generate these downstream signals DS1, DS2, DS3 at the respective downstream wavelengths assigned to the ONUs.

Furthermore, for transmitting upstream signals US1, US2, US3 at respective upstream wavelengths from the ONUs to the OLT, the ONUs need to generate their respective upstream signals US1, US2, US3 at the respective upstream wavelengths assigned to the ONUs.

### Description of Embodiments

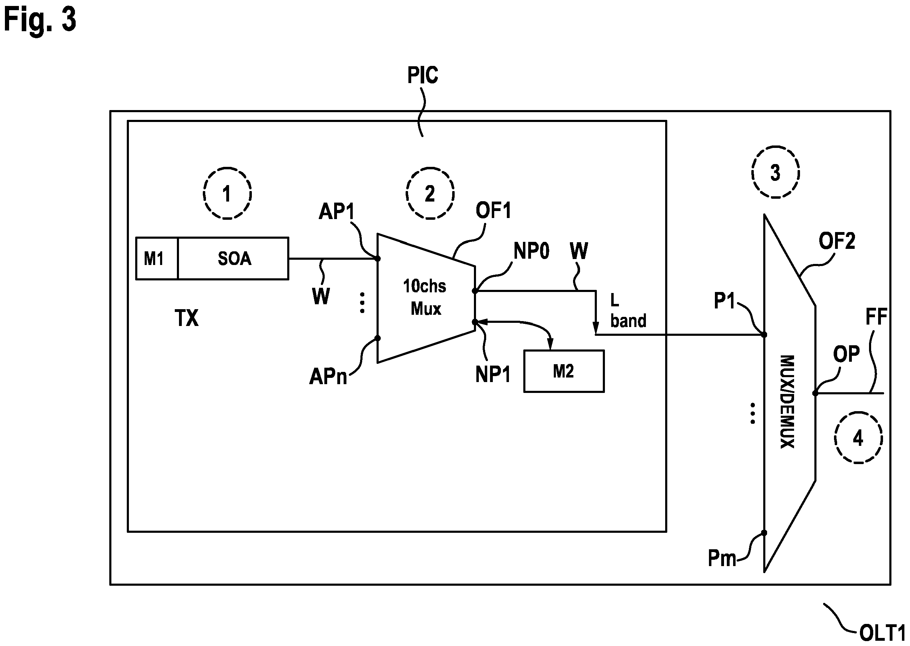

Figure 3 shows an embodiment of an optical line terminal OLT1 as an optical transmitter for an optical access network. The optical line terminal OLT1 contains in a transmission unit TX a semi-conductor optical amplifier SOA. A mirror M1 is located, such that an optical signal emitted by the amplifier SOA towards the mirror M1 is reflected back to the amplifier SOA. The optical line terminal OLT1 contains furthermore a first optical filter OF1 and a second optical filter OF2, as well as a second mirror M2.

An optical signal that is emitted by the amplifier SOA towards the optical filter OF1 reaches the filter OF1 via a waveguide W. The filters OF1 and OF2 are connected in serials connection to each other by a further waveguide or optical fiber W. The mirror M2 is coupled to the first filter OF1.

The mirrors M1 and M2 delimit a cavity, which contains the amplifier SOA and the first further OF1.

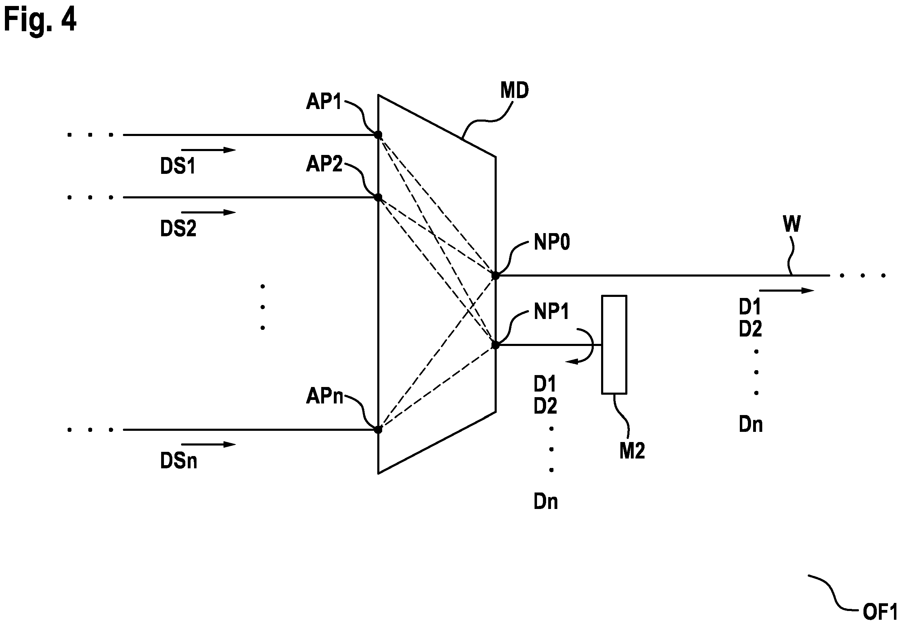

Preferably, the optical filter OF1 is a wavelength dependent multiplexer / demultiplexer. More preferably, the filter OF1 is a cyclic arrayed waveguide grating (AWG), which will be explained in more detail according to Figure 4.

The arrayed waveguide grating as the optical filter OF1 contains a number of amplifier-sided ports AP1, ... , APn, to which respective optical amplifiers SOA may be connected. Furthermore, according to the embodiment shown in Figure 3, the AWG contains two network sided ports NP0, NP1. The first network sided port NP0 is connected via the waveguide W to a port P2 of the second filter OF2. The second mirror M2 is connected to the second network sided port NP1 of the AWG.

The second optical filter OF2 is preferably a wavelength dependent multiplexer / demultiplexer. More preferably, the optical filter OF2 is a non-cyclic arrayed waveguide grating, which contains a number of incoming ports P1, ..., Pn and one outgoing port 0P, to which the feeder fibre FF may be connected. The exact mode of operation of the second filter OF2 will be described in detail later on. More preferably the optical filter OF2 is a thin-film filter (TFF) based wavelength multiplexer/demultiplexer.

Coming to Figure 4, the mode of operation of the first filter OF1 as a cyclic AWG with two outgoing ports NP0, NP1 will now be described in more detail.

Figure 4 shows an embodiment of the first wavelength dependent filter in the form of a wavelength dependent multiplexer/demultiplexer MD (briefly termed herein after mux/demux), to which the second mirror M2 is coupled.

The mux/demux MD is preferably an AWG having a first network sided port NP0, a second network sided port NP1 and n amplifier sided ports AP1, AP2, ... APn. The AWG preferably is an athermal AWG. In this example, the number of amplifier sided ports is n=10. Thus, up to n=10 different semiconductor optical amplifiers may be connected to the mux/demux MD. At the n amplifier sided ports AP1, AP2, ... APn, respective downstream signals DS1, ..., DSn may be received from respective optical amplifiers.

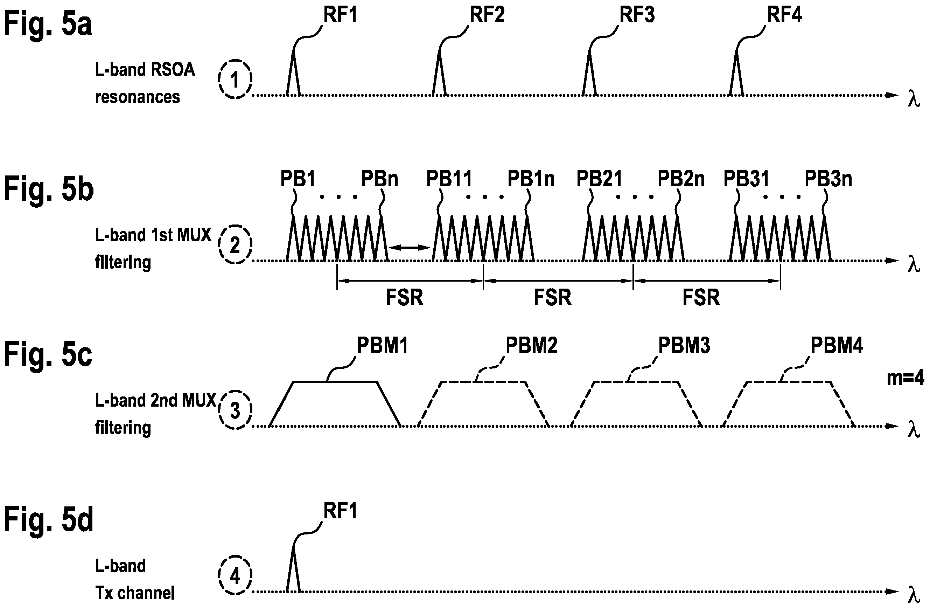

Figure 5b shows on the left hand side the passband transfer function characteristics PB1, ..., PBn of the respective ports AP1, ..., APn of Figure 4. The mux/demux MD is preferably a cyclic AWG, such that each amplifier sided port AP1 has not only one passband transfer function PB,1 but multiple passbands transfer function PB1, P11, PB21, PB31, which are separated by the free spectral range FSR of the cyclic AWG. In this example, each amplifier sided port AP1 has four passbands PB1, PB11, PB21, PB31 In other words, multiple passbands PB1, P11, PB21, PB31 are assigned to a single amplifier sided port AP1. Same considerations hold for the amplifier sided ports AP2, ..., APn.

Coming back to Figure 4, the first network sided port NP0 is preferably the port at which an mth diffraction order (m being equal to 0, 1, 2, etc.) of optical signals entering the mux/demux MD through the amplifier sided ports AP1, ..., UPn and having wavelengths equal to the respective downstream wavelengths focuses. Further, the second network sided port NP1 is preferably the port at which an (m+k)th or (m-k)th diffraction order (k being an integer equal to or higher than 1, preferably equal to 1) of optical signals entering the mux/demux MD through the amplifier sided ports AP1, ..., APn and having wavelengths equal to the respective downstream wavelengths focuses. The first network sided port NP0 is preferably connected to a waveguide W, while the second network sided port NP1 is preferably connected to the second mirror M2.

The second mirror M2 may have has a reflectivity substantially constant over the whole wavebands B1 and B2 shown in Figure 2. For instance, the second mirror M2 may comprise a metallic coating. Alternatively, the reflectivity of the second mirror M2 may vary versus wavelength, and is preferably higher in the second waveband B2 than in the first waveband B2, wherein in the example given in Figure 4 the downstream band is B2 as the L-band. This wavelength-dependent behavior may be obtained for instance by means of a thin-film filter incorporated in the second mirror M2. The mirror can also comprise a Faraday Rotator Mirror.

Coming back to Figure 3, it may be noticed that within the optical transmitter OLT1 there are n cavities advantageously formed, one per each optical amplifier. In particular, by referring for instance only to the amplifier SOA connected to the port AP1, its associated cavity is delimited at its ends by the first mirror M1 and the second mirror M2, and comprises: the optical amplifier SOA, the waveguide W1 and the optical filter OF1 as a mux/demux. In particular, the mux/demux contains the diffraction path joining the amplifier sided port AP1 and the second network sided port NP2.

The reflectivity of the first mirror M1, the gain of the optical amplifier SOA, the reflectivity of the second mirror M2 and the passband transfer functions PB1, PB11, PB21, PB31, shown in Figure 5b, between the amplifier sided port AP1 and the second network sided port NP2 of the mux/demux determine the resonance frequencies RF1, RF2, RF3, RF4, shown in Figure 5a, at which this cavity emits a coherent optical signal. In the example given in Figure 5a, the optical gain spectrum of the RSOA covers a bandwidth that is at least the bandwidth of four times the free spectral distance of the AWG as the first filter OF1 in Figure 3.

The optical amplifier SOA preferably has a spectral bandwidth coincident with the waveband B2, which is preferably the L-band as the downstream band. This advantageously triggers a positive feedback mechanism in the cavity, that induces the cavity to emit a coherent optical radiation in the downstream direction at its output (i.e. at the first network sided port NP0).

The final single emission wavelength of the coherent optical signal that is transmitted into the feeder fiber FF is furthermore determined by the passband characterics of the second optical filter OF2.

By looking at Figure 3 in conjunction with Figure 5a and Figure 5b, it becomes evident, that the resonant frequencies RF1, ..., RF4, at which the optical amplifier SOA generates multiple modes of the basic signal RF1, is defined by the choice of the port AP1, to which the amplifier SOA is connected, due to the fact, that this port AP1 has a pass-band characteristic that is cyclic PB1, PB11, PB21, PB31, as shown in Figure 5b.

It will now be explained in detail, in which way the mode of operation of the second filter OF2 as an AWG or a TFF selects a single one of the resonant frequencies shown in Figure 5a.

The AWG as the filter OF2 contains the incoming ports P1, ... , PM, with respective pass-bands PM1, ... , PBM4, as shown in Figure 5c. In this example, the number of ports and pass-bands is chosen to m=4. As it is shown in Figure 3, the optical amplifier SOA is connected indirectly via the filter OF1 to the first port P1 of the second filter OF2. Therefore, a signal coming in at the port P1 is subject to the pass-band PBM1 shown in Figure 5a. Thus, by choosing the port P1 of the filter OF2 with the respective pass-band transfer function PBM1 shown in Figure 5c, it is determined, that the signal that is transmitted into the feeder fiber FF via the output port OP is the signal RF1, as shown in Figure 5d.

It becomes clear, that by choosing one of the amplifier sided ports AP1, ... , APn of the first filter OF1 and by choosing furthermore one of the ports P1, ... , PM of the second further OF2 different ones of the pass-band characteristics shown in Figure 5b and 5c can be chosen, for defining that final single wavelength, at which a downstream signal is transmitted by the optical line terminal OLT1 into the feeder fiber FF.

The spacing of the multimode signals as the resonant frequencies RF1, ... , RF4 shown in Figure 5a, is essentially equal to the free spectral range FSR of the first filter OF1, as shown in Figure 5b.

It is evident, that by connecting more than one optical amplifier SOA, as shown in Figure 3, to respective ports AP1, ... , APn, multiple downstream signals at respective different wavelengths can be generated by the optical line terminal OL21 shown in Figure 3.

The number n of the ports AP1, ... , APn of the filter OF1 may be chosen to n=10, as an example. Preferably, the number n of the ports AP1, ... , APn is chosen within the range of n=4 ... 12.

The elements of the mirrors M1, M2, the amplifier SOA as well as the waveguides in the first filter OF1 can be integrated on a photonic integrated circuit PIC. To each of the ports P1, ..., Pm of the second filter OF2, the respective photonic integrated circuit with respective multiple amplifiers may be connected. Therefore, even more multiple downstream signals can be generated by the optical line terminal OLT1. In detail, the terminal OLT1 could generate up to n-times m different downstream signals in such a manner.

Preferably, the amplifier SOA is a reflective semi-conductor amplifier RSOA, which contains the first mirror M1 as an integral part. Even furthermore, the amplifier SOA not only amplifies optical signals present at the amplifier SOA, but also modulates optical signals emitted by amplifier SOA. By this, the amplifier SOA is adapted to perform amplitude modulation of the signal emitted by the amplifier SOA.

The mirror M2 is preferably a standard mirror if the mirror M2 is not integrated on the photonic integrated circuit PIC but connected to it through a polarization maintaing fiber.

An integration of the mirrors M1 and M2 together with the amplifier SOA into the photonic integrated circuit achieves to maintain a polarization state of the optical signals within the photonic integrated circuit.

For achieving a higher flexibility for choosing the resulting wavelength of the downstream signal generated by photonic integrated circuits PIC, multiple photonic integrated circuits may be connected to the incoming ports P1, ... , Pm of the filter PF2 by means of an optical cross-connecting switch. This allows for a higher flexibility of choosing that final single wavelength, at which a photonic integrated circuit and the respective amplifier SOA generate a downstream signal, which is then transmitted into the feeder fiber FF.

The advantage of integrating elements of the terminal OLT1 into a photonic integrated circuit is that of cost reduction, lower power dissipation and smaller footprint.

Coming back to Figure 3, when using amplitude modulation, the cavity signal that is transmitted at a first time instance partially towards the second filter OF2 and also partially towards the second mirror M2 to the optical amplifier SOA carries an amplitude modulation. The partial signal that is transmitted back by the mirror M2 within the cavity towards the first filter OF1 and also the amplifier SOA carries a residual modulation. This residual modulation superposes the modulation level of a new modulated signal, that is to be generated and transmitted at a next time instance.

Thus, the optical amplifier SOA performs a high-pass filtering function on the cavity signal, which substantially cancels the residual amplitude modulation of the signal generated at the first time instance. This high-pass filtering function is caused by the known self-gain modulation effect occurring in the optical amplifier SOA. Hence, the quality of the new amplitude-modulated downstream signal is not impaired by the residual modulation of the cavity signal. Further, suppression of the residual modulation advantageously allows generating upstream signals at a very high speed (namely, Gigabit/s). The high-pass filtering function of the optical amplifier OA depends, among other parameters, on the input optical power at the optical amplifier OA and its effectiveness is proportional to the input optical power. Thus the cavity operation, which inherently guarantees strong steady-state feedback, which means that the cavity signal has very high optical power in steady state conditions, advantageously increases efficiency of the self-gain modulation effect occurring in the optical amplifier SOA and, accordingly, cancels the residual amplitude modulation of the reflected cavity signal in a very efficient way. Optionally, this high pass filtering effect can be further increased by electrical signal processing techniques, such as Feed-Forward Current Injection (FFCI).

In detail, the saturated output power of the optical amplifier SOA has to be high enough to overcome the cavity losses and guarantee an optical feedback in the optical amplifier SOA at power levels above the saturation input power. For example, realistic overall cavity losses are 14/19dB, thus with a realistic amplifier minimum output power of +4dBm the input saturation power of the amplifier should be in the range - 15/-10dBm.

As previously mentioned, modulation may be carried out by means of amplitude modulation. Thus, when modulating the generated optical signal with a specific amplitude for transmitting a bit, then the bit duration time τ_{bit} defines the duration during which the amplitude level is supposed to be constant. To operate the cavity in a manner which guarantees a generation of a resonant, as shown in Figure 5d, it is desirable that the cavity's round trip time τ_{round} is a multiple of the bit duration time τ_{bit} , which means that preferably the cavity's round trip time τ_{round} is chosen in the range of τ_{round} >10 τ_{bit} or even τ_{round} >100 τ_{bit}. For example at 1Gb/s the resulting bit duration time τ_{bit} is 1 ns; thus a cavity with refractive index n=1.5 (optical fiber or silica planar waveguide) should have a minimum length of > 1m in order to guarantee a cavity's round trip time of τ_{round}>10ns. At 10Gb/s instead a desirable minimum cavity length of 10cm is sufficient. The optical delay line to achieve the minimum cavity length can be integrated in the OLT PIC in different ways, depending on its length. It can be integrated on the Planar Lightwave Circuit (PLC) where the AWG is for lengths of to some tens of centimetres, the higher the refractive index of the PLC waveguide, the shortest the physical delay line length. Or it can be integrated as an optical fiber pigtailed to the PLC and routed inside the PIC package for lengths up to some meters. The minimum cavity length is chosen in dependence on the desired data rate and the refractive index of the cavity.

As it has been explained in detail with regard to Figure 3, the second mirror M2 is coupled to the first filter OF1 via a second port NP1 of the first filter OF1 in the form of an AWG.

According to an alternative solution, the AWG contains only a single network sided port NP0, while the second mirror M2 is coupled to the waveguide W by means of a power splitter, which splits power of an optical signal coming from the network sided port NP0 partially on to the mirror M2 and also partially onto the waveguide W that is connected to the second filter OF2. In this alternative solution, an optical signal coming in from the waveguide W to the mirror M2 is reflected back from this mirror and then coupled back by the optical coupler into the waveguide W towards the network sided port NP0 of the optical filter OF1.

Preferably, the second mirror M2 is a faraday rotating mirror, such that a signal reflected back by the mirror M2 lies essentially within a preferred polarization plane. This has the advantage, that an optical signal reflected back by the mirror M2 towards the filter OF1 and also towards the amplifier SOA lies within such a polarization plane, for which the amplifier SOA has an optimized gain spectrum.

According to an even further alternative solution, the optical filter OF1 is an arrayed waveguide grating as previously described, which contains only a single network-sided port NP0. According to this even further alternative solution, the second mirror M2 is placed within the waveguide W connecting the first filter OF1 and the second filter OF2, while the second mirror M2 is a partially reflecting mirror. Thus, the second mirror M2 as a partially reflector mirror reflects a partial optical signal back to the port NP0 of the filter OF1 and thus also back to the amplifier SOA, while another partial optical signal coming from the port NP0 passes the mirror M2 towards the port P1 of the optical filter OF2. Even furthermore, it is an even further alternative solution, that the second optical mirror is a faraday rotating mirror that is partially reflective.

According to Figure 3, the second filter OF2 is an integral part of the terminal OLT1. According to an alternative solution, the terminal OLT1 does not contain the second filter OF2, but the second filter OF2 is a separate device located outside out of the terminal OLT1.

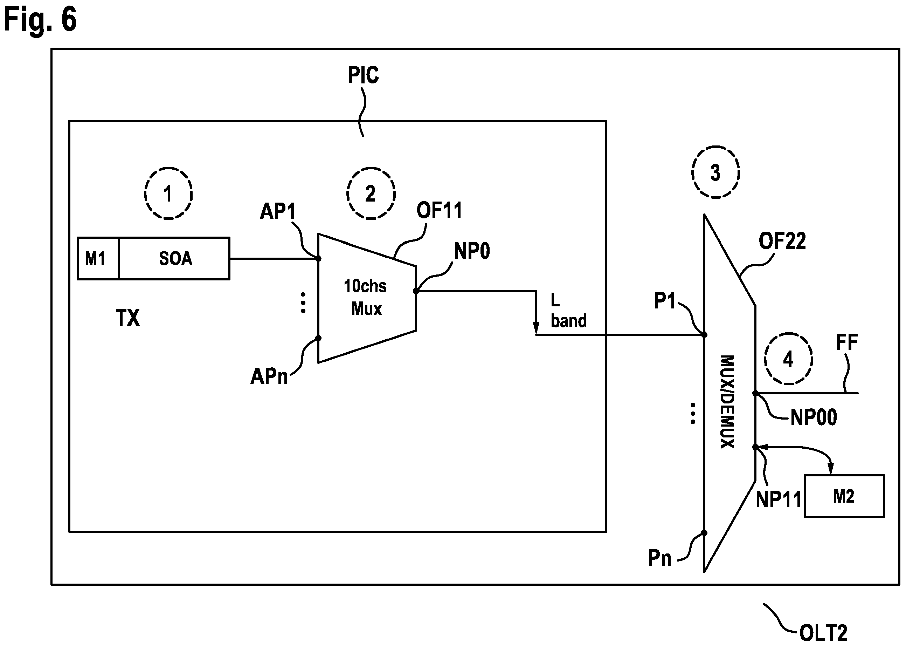

Figure 6 shows an alternative solution of an optical line terminal OLT2.

Figure 6 contains all elements previously described with regard to Figure 3, except for the fact, that the first filter OF11 is a cyclic AWG, that contains only a single network sided port NP0, while the second filter OF22 is a non-cyclic AWG, that contains a first network sided port NP00 as well as a second network sided port NP11. More preferably, the optical filter OF22 is a thin-film filter (TFF) based multiplexer / demultiplexer. The mode of operation of the AWG as the filter OF22 with regard to the network-sided ports NP00, NP11 is essentially equal to the mode of operation of the AWG previously described in Figure 4, which also contains two network sided port NP0, NP1.

Furthermore, according to Figure 6, the second mirror M2 is not coupled to the first filter OF11, but to the second port NP11 of the second filter OF22.

In this case, as shown in Figure 6, the cavity that is defined by the mirrors M1, M2 contains both optical filters OF11, OF22. As previously described with regard to Figure 3, the optical amplifier SOA may contain the mirror M1 as an integral part. Even furthermore, as previously described with regard to Figure 3, the second mirror M2 may be coupled not to the second network sided port NP11, but via a coupling unit such as an optical coupler to the feeder fiber FF. Even furthermore, the second mirror M2 may be placed within the optical path of the feeder fiber FF. Preferably, the second mirror M2 is a partially reflecting mirror or a partially reflecting faraday rotating mirror.

The mode of operation of the optical line terminal OLT2 shown in Figure 6 is essentially equal to the mode of operation of the optical line terminal shown in Figure 3, except for the fact that the cavity defined by the mirrors M1, M2 contains also the second filter OF22. With regard to pass-bands and resonant frequencies, the mode of operation of the optical line terminal OLT2 shown in Figure 6 is essentially equal to that of the optical line terminal shown in Figure 3, as it has been described in detail previously with regard to Figure 5.

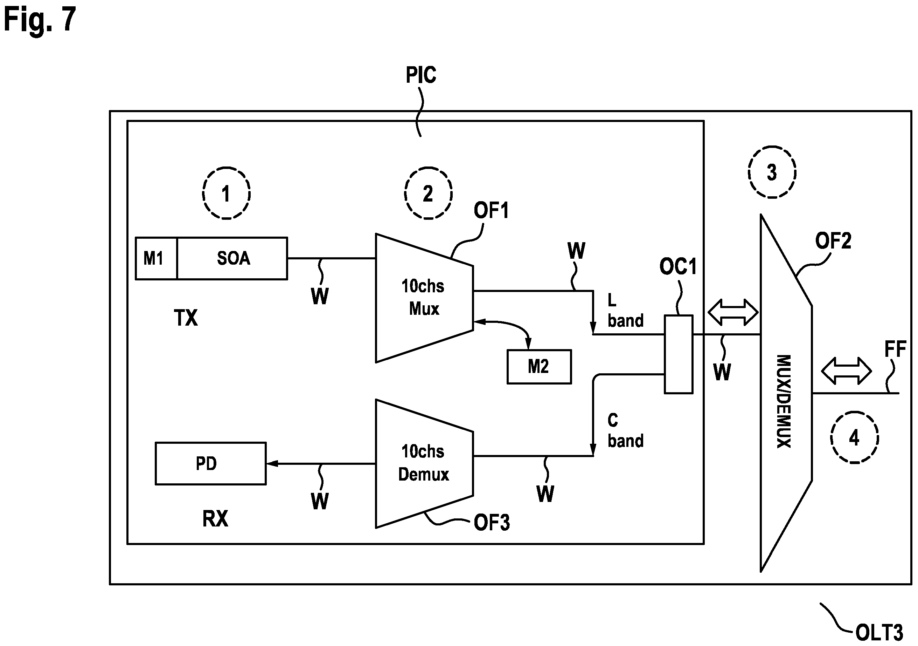

Figure 7 shows an optical line terminal OLT according to an even further embodiment. The optical line terminal OLT 3 shown in Figure 7 contains all elements as previously described with regard to Figure 3. Furthermore, the optical line terminal OLT3 contains an optical coupler OC1, which couples the waveguide W connecting the filters OF1, OF2 and a further waveguide W, which is connected to a third optical filter OF3. In this solution shown in Figure 7, the second filter OF2 is a cyclic mux/demux with a free spectral range equal to the distance between the C-band and the L-band. Preferably, the second filter OF2 is a cyclic AWG, that contains a first network sided port NP00 as well as a second network sided port NP11. More preferably, the optical filter OF22 is a thin-film filter (TFF) based multiplexer / demultiplexer followed by splitters and/or combiners in order to implement the cyclic transfer function with a free spectral range equal to the distance between the C-band and the L-band.

The third optical filter OF3 is preferably an optical demultiplexer, which demultiplexes different wavelengths lying within the C band, as the band B1, of the upstream signals onto different receivers RX. The receivers contain preferably a photodiode PD. For illustrational purposes, only one photodiode PD is shown in Figure 7, while it is clearly understood that multiple photodiodes PD may be connected to respective different ports of the filter OF3.

The optical coupler OC1 acts as a filtering element, which splits upstream signals lying within the C band coming from the feeder fiber FF onto the waveguide W leading to the filter OF3. Even furthermore, the second optical filter OF2 is preferably a cyclic AWG, which has a cyclicity with a free spectral range that is equal to the spectral distance between the L band of the downstream signals and the C band of the upstream signals.

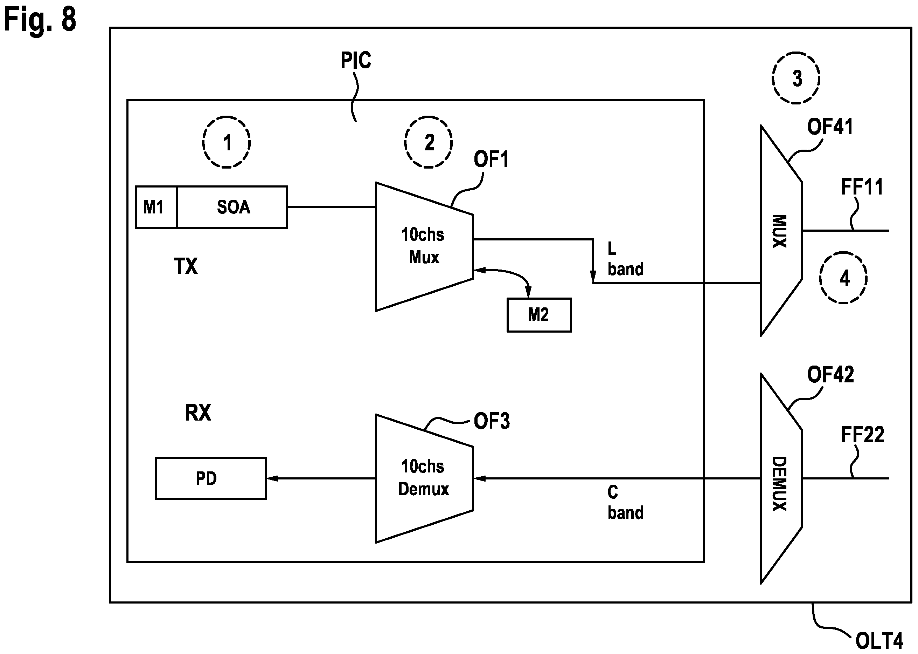

Figure 8 shows an optical line terminal OLT4 according to an even further embodiment.

According to Figure 8, a photonic integrated circuit PIC contains a transmission section TX that is equal to the transmission section previously described with regard to Figure 3. Furthermore, the photonic integrated circuit PIC contains a receiver section RX, which is essentially equal to the receiving section RX as previously described with regard to Figure 7. This receiving section RX contains an optical filter OF3, to which multiple photodiodes PD may be connected to respective ports of the filter OF3.

Furthermore, an optical filter OF41 is provided in the form of a non-cyclic wavelength dependent multiplexer / demultiplexer which operates in the L band of the downstream signals in an equal mode of operation as previously described for the filter OF2 in Figure 3.

The filter OF41 is preferably connected to a feeder fiber FF11 that is used for downstream transmission.

A further optical filter OF42 is provided as a demultiplexing unit as a non-cyclic wavelength dependent multiplexer/demultiplexer, that is connected to a feeder fiber FF22, which may be used for transmission of upstream signals in the C band. The filter OF42 has a mode of operation within the C band, that is equivalent to the mode of operation of the filter OF41 in the L band.

The filters OF41 and OF42 may be an integral part of the optical line terminal OLT4 shown in Figure 8. Alternatively, the filters OF41 and OF42 are devices separate from the optical line terminal OLT4 shown in Figure 8.

It has to be mentioned with regard to the Figures 7 and 8, that a coupling of the second mirror M2 to the optical filter may be provided according to the different alternative solutions that have been described previously with regard to Figure 3.

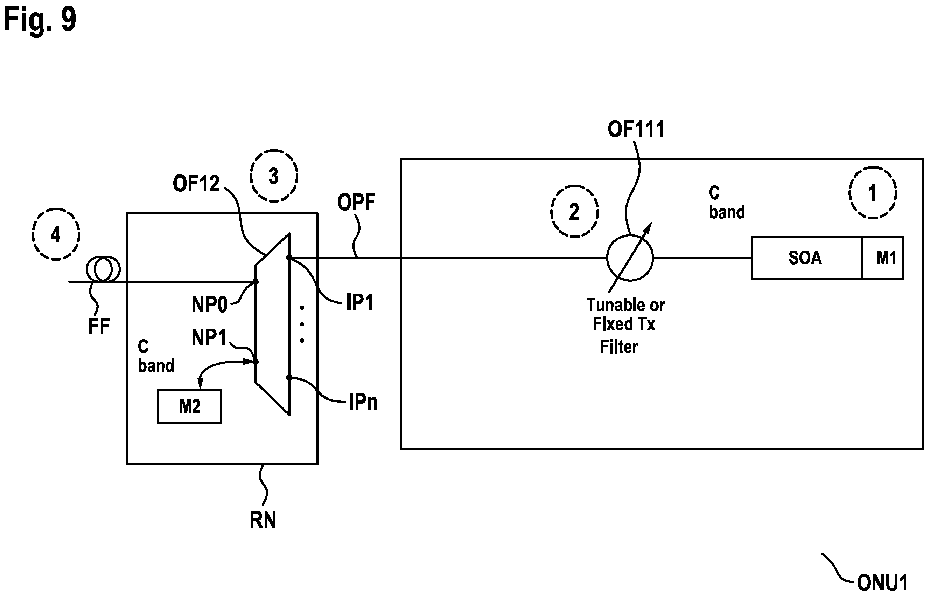

Figure 9 shows an optical network unit ONU1, which is connected to a remote node RN. The optical network unit ONU1 together with the remote node RN forms an optical transmitter for an upstream signal in the C band. The remote node RN is connected to feeder fiber FF. The remote node and the optical network unit ONU1 are connected to each other by an optical fiber OPF.

The optical network unit ONU1 contains an optical amplifier SOA, which is placed next to the first mirror M1. As previously described with regard to Figure 3, the mirror M1 may be an integral part of the semiconductor optical amplifier SOA. The optical network unit ONU1 contains furthermore an optical filter OF111, which may be a tunable or a fixed filter. Even furthermore, the mirror M1 is preferably a faraday rotating mirror, which reflects an incoming optical signal, such that the reflected optical signal lies essentially within a preferred polarization plane. This is of advantage, since an amplifier SOA may have a gain spectrum with an optimized gain for preferred polarization planes.

The remote node RN contains an optical filter OF12 in the form of an arrayed waveguide grating with two network sided ports NP0, NP1 as well as a number of incoming ports IP1, ... , IPn.

The combination of a tunable filter OF111 at the optical network unit ONU1 together with an AWG at the remote node allows to determine that downstream wavelength, at which the ONU receives a downstream signal, by tuning the optical filter. Thus, in this concept, the optical network unit ONU1 is in general capable of receiving one out of different downstream signals from different OLTs of different providers.

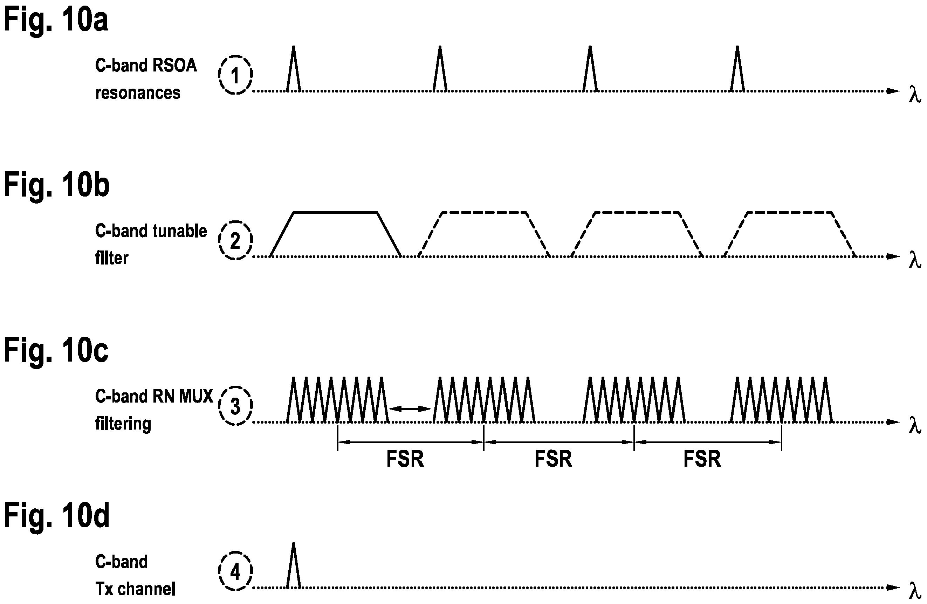

The filter OF12 is essentially equal to the filter OF1 in the form of a cyclic AWG, as previously described with regard to Figure 4, but with the difference that the different pass-bands of the incoming ports IP1, ... , IPn lie within the upstream band as the C band, as depicted in Figure 10c. The filter OF12 is preferably an athermal filter. The filter OF12 has preferably a free spectral range equal to the distance between the C-band and the L-band.

The tunable or fixed filter OF111 is placed in the optical path between the semiconductor optical amplifier SOA and the second filter OF12. The filter OF111 has preferably a pass-band characteristic as it is depicted in Figure 10b.

Preferably, the cavity that is delimited by the mirrors M1 and M2 is chosen, such that in general different frequencies as depicted in Figure 10a are generated as resonant frequencies, while the choice of the input port IP1, to which the amplifier SOA and the filter OF111 are connected, as well as the choice of the pass-band characteristic of the filter OF111, as shown in Figure 10b, determine the single wavelength, at which an upstream signal is emitted at the remote node towards the feeder fiber. This single wavelength is depicted in Figure 10d.

In the case, that the filter OF111 is a tunable filter, this allows for choosing out of the possible resonant frequencies shown in Figure 10a that frequency, which will be finally transmitted at the remote node into the feeder fiber, by selecting one of the pass-bands as shown in Figure 10b.

Even furthermore, the second mirror M2 may not be coupled to the second network-sided port NP1, but instead to the feeder fiber FF via an optical splitting unit. In this case, the filter OF12 is a cyclic AWG with just one single network-sided port NPO. Such a solution of coupling the mirror M2 to an AWG with a single network-sided port NPO has been previously described with regard to Figure 3.

Even furthermore, the mirror M2 may be placed in the optical path between feeder fiber FF and the filter OF111, while in this case the mirror M2 is a partially reflecting mirror, as it has been described previously as an alternative solution with regard to Figure 3. As described previously with regard to Figure 3, the mirror M2 may be preferably a faraday rotating mirror. According to an even further alternative solution, a faraday rotator may be placed in the optical path between the filter OF111 and the filter OF12 for keeping the signal that is reflected back by the mirror M2 within essentially a single polarization plane, such that the semi-conductor optical amplifier SOA is provided with the reflected optical signal within such a polarization plane, for which the amplifier SOA has an optimized gain spectrum. Preferably, the mirror M2 is a faraday rotating mirror.

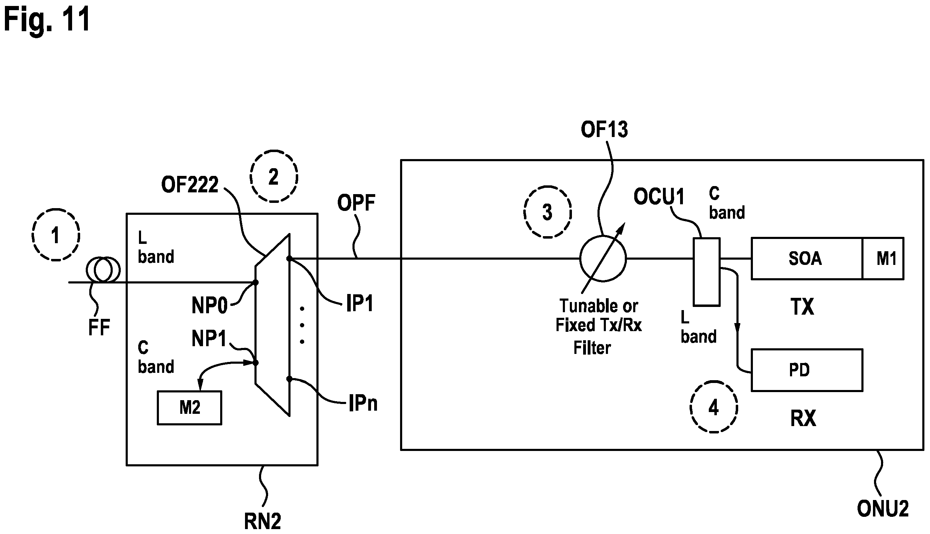

Figure 11 shows a further embodiment of an optical network unit ONU2, which contains all elements as previously described with regard to Figure 9. Furthermore, the

Figure 11 shows a remote node RN2, which has for the upstream signals and the C band a mode of operation that is equal to the mode of operation of the filter OF12 shown in Figure 9.

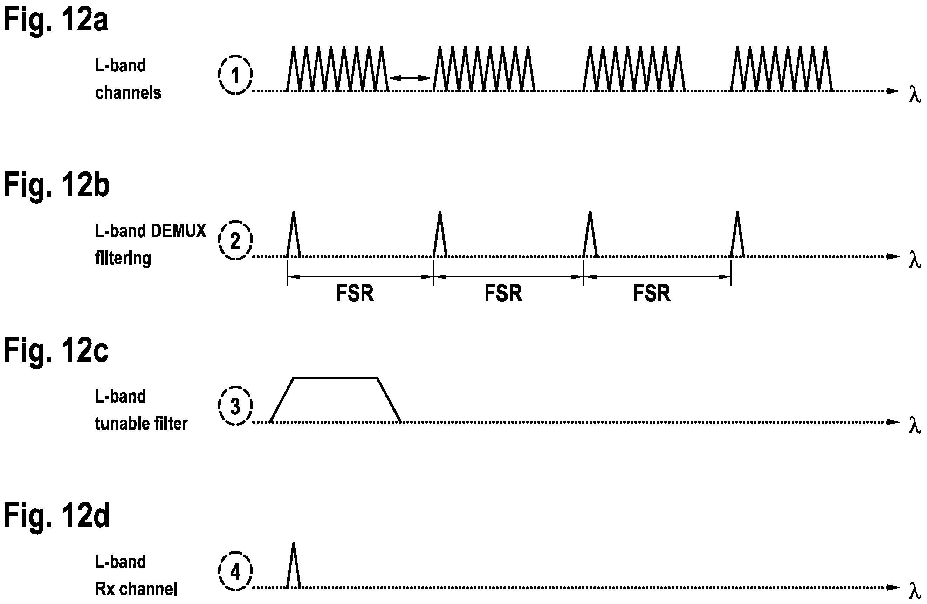

For the downstream signals in the L band, the filter OF222 has with respect to the first port IP1 a passband transfer function as depicted in Figure 12b. Therefore, different channels or signals coming in at the downstream L band, as shown in Figure 12a, are filtered towards the port IP1 of the filter OF222 in Figure 11 as shown in Figure 12b. Clearly, the filter OF222 is a cyclic AWG, preferably athermal, that has a free spectral range as shown in Figure 12b. Thus, after filtering the downstream signals of the L band with the transfer function shown in Figure 12b of the filter OF222, multiple frequencies as corresponding to the passband transfer functions shown in Figure 11 remain present before reaching the filter OF13 within the optical network unit ONU2. The optical filter OF13 is preferably a cyclic tunable filter, which has a free spectral range that is equal to the distance of the L band of the downstream signals to the C band of the upstream signals. The tunable filter OF13 can be for example a tunable ring resonator.

Within the L band, the filter OF13 has a pass-band transfer function as shown in Figure 12c. Therefore, a single one of the possible resonant frequencies shown in Figure 12b are filtered out by the pass-band function shown in Figure 12c, which results in the single wavelength shown in Figure 12d present after the filter OF13.

Clearly, the choice of the port IP1 with its respective transfer functions of the filter OF222 together with the passband transfer function of the filter OF13 determine that wavelength, shown in Figure 12d, at which a downstream signal is received.

At an optical coupling unit OCU1, the received downstream signal with the single wavelength is coupled out, due to the fact that the optical coupling unit OCU1 splits the bandwidth of the C band from the bandwidth of the L band. Thus, the optical coupling unit OCU1 provides the received downstream signal at the single wavelength depicted in Figure 12d to the receiving unit RX, which is provided in the form of a photodiode.

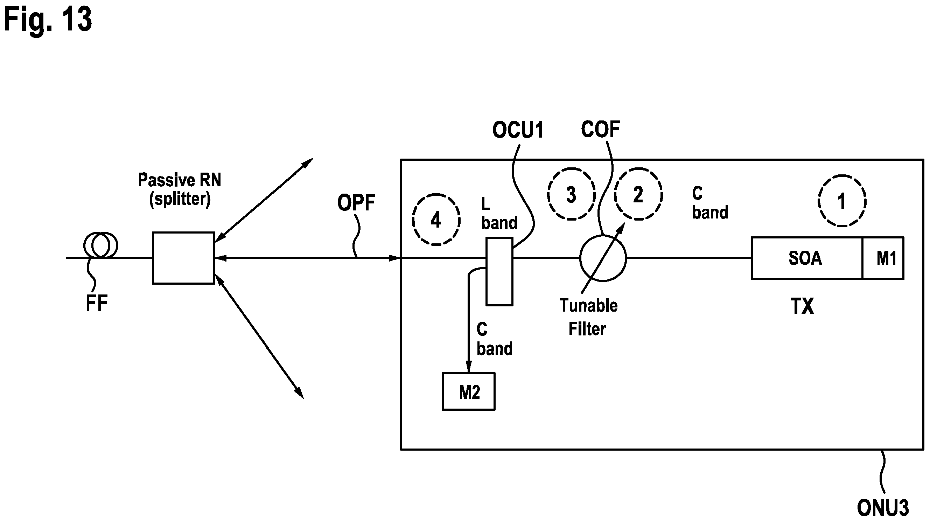

Figure 13 shows an even further embodiment of an optical network unit ONU3. The optical network unit ONU3 contains a semiconductor optical amplifier SOA as well as a mirror M1, as previously described with regard to the Figures 9 and 11.

Furthermore, the optical network unit ONU3 contains a combined optical filter COF, which has in the upstream band, the C-band, a combined pass-band characteristic as previously described with regard to the Figures 10b and c, while the combined optical filter COF has a pass-band characteristic in the L band for downstream signals as previously described with regard to the Figures 12b and c. The combined optical filter COF is preferably a combination of a tunable filter OF13, as previously described with regard to Figure 11, and a cyclic wavelength mux/demux, preferably a cyclic AWG, as described previously with regard to Figure 11.

The combined optical filter COF is followed by an optical coupling unit OCU1, which is identical to the optical coupling unit OCU1 previously described with Figure 11. The second mirror M2 is coupled to the optical coupling unit OCU1 in the C band of the upstream signals. Preferably, the coupler OCU1 in this embodiment is simply an optical coupler, not necessarily a C/L band separator/combiner since the amplifier SOA has a gain spectrum in the upstream C band only. Thus, the mirrors M1 and M2 delimit a cavity, which contains the amplifier SOA as well as two filters in the form of a combined optical filter COF.

Within the C band of the upstream signals, the choice of the transfer functions of the combined optic filters COF leads to a single emitted upstream signal within the C band as it has been previously described with regard to the Figures 9, 10 and 11. Furthermore, the optical network unit performs a filtering of received downstream signals as it has been described with regard to Figures 12a to d previously.

Furthermore according to Figure 13, an even further optical network unit ONU4 is shown. The advantage of the optical network unit ONU3 shown in Figure 13 is, that all filtering within the L band and the C band of the downstream and the upstream signals is performed within the optical network unit ONU3 itself, while the remote node RN, to which the optical network unit ONU3 is connected via an optical wire OPF, may be a passive power splitter.

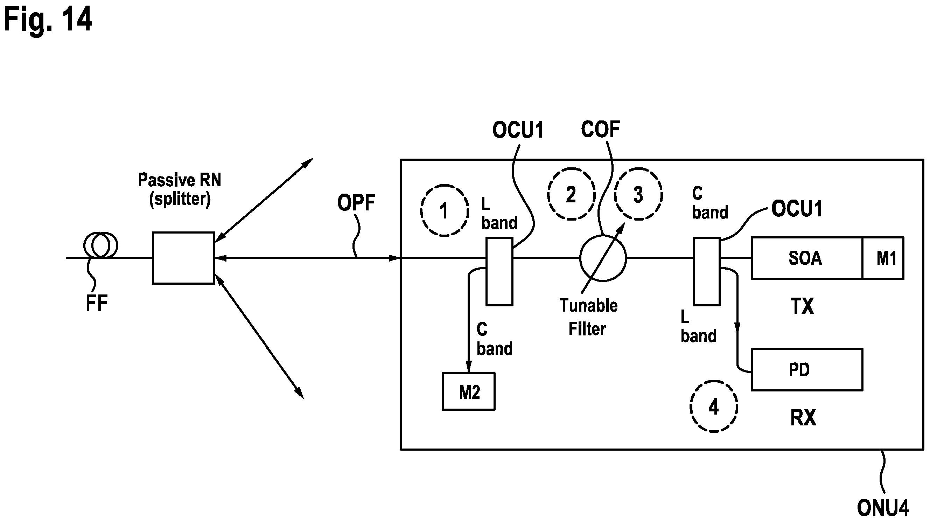

According to Figure 14 the optical network unit ONU4 contains all elements as previously described with regard to Figure 13. Furthermore, the optical network unit ONU4 contains furthermore an optical coupling unit OCU1 that is placed between the optical amplifier SOA and the combined optical filter COF. This is an optical coupling unit OCU1, as it has been previously described with regard to Figure 11, and which provides downstream signals in the L band to a photodiode PD.

It has to be noted, that in all of the different embodiments of the optical line terminals and the optical network units, these devices are optical transmitters, which transmit a coherent signal, by using a cavity that is delimited by two mirrors, wherein the cavity contains an optical amplifier as well as at least one optical filter, and that the resulting transmitted single wavelength of the transmitted signal is defined by the pass-bands of the two optical filters used in the different devices. In the case of the optical network units explained in the Figures 9 and 11 the optical transmitter contains also the remote node.

The description given for the proposed optical transmitters using the L-band for downstream signals and the C-band for upstream signals is a non-limiting example. Other frequency bands may be used downstream and upstream signals.

The optical transmitters described herein are preferably optical transmitters for use in a WDM optical access network. More preferably, the optical transmitters described herein are optical transmitters for use in a WDM optical network such as a metro network, wherein such an optical transmitter may be used for optical WDM transmission via an optical link of such a WDM metro network.

To summarize the different solutions for an optical transmitter OLT1, OLT2, OLT3, OLT4, ONU1, ONU2, ONU3, ONU4, RN as described with regard to the Figures 3, 6, 7, 8, 9, 11, 13, and 14, it has to be mentioned that at least these solutions of an optical transmitter comprise a first mirror M1 and a second mirror M2, semiconductor optical amplifier SOA, a first optical filter OF1, OF11, OF111, OF13, COF and a second optical filter OF2, OF22, OF41, OF12, OF222, COF, wherein the first optical filter OF1, OF11, OF111, OF13, COF and the second optical filter OF2, OF22, OF41, OF12, OF222, COF are in series connection to each other, wherein the first mirror M1 is located, such that a first fraction of an optical signal emitted by the semiconductor optical amplifier SOA is reflected back to the semiconductor optical amplifier SOA, wherein a second fraction of an optical signal emitted by the semiconductor optical amplifier SOA is transmitted towards the series connection of the optical filters, and wherein the second mirror M2 is optically coupled to the first or the second filter, such that the first and the second mirror M1, M2 delimit a cavity, which comprises the semiconductor optical amplifier SOA and at least one of the optical filters and which is adapted to generate a coherent optical signal. Furthermore, it has to be mentioned that these solutions for an optical transmitter OLT1, OLT2, OLT3, OLT4, ONU1, ONU2, ONU3, ONU4, RN as described with regard to the Figures 3, 6, 7, 8, 9, 11, 13, and 14, propose an optical transmitter OLT1, OLT2, OLT3, OLT4, ONU1, ONU2, ONU3, ONU4, RN, wherein the optical filters are wavelength dependent passband filters, and wherein the passband transfer functions of the optical filters acting on the optical signal determine that wavelength, at which an optical signal is transmitted by the optical transmitter, wherein a wavelength mux/demux is a passband filter depending on the port used for connecting the two optical filters M1, M2 and the semiconductor optical amplifier SOA.

To summarize the different solutions for an optical transmitter OLT1, OLT2, OLT3, OLT4 as described with regard to the Figures 3, 6, 7 and 8, it has to be mentioned that at least these solutions of an optical transmitter are such, in which one of the filters is a cyclic wavelength multiplexer/demultiplexer with a free spectral range smaller than a downstream transmission bandwidth B2, and in which the other of the filters is a wavelength multiplexer/demultiplexer.

To summarize the different solutions for an optical transmitter OLT1, OLT2, OLT3, OLT4 as described with regard to the Figures 3, 6, 7 and 8, it has to be mentioned that at least these solutions of an optical transmitter are such, in which the second mirror M2 is optically coupled to the first filter OF1.

To summarize the different solutions for an optical transmitter OLT1, OLT2, OLT3, OLT4 as described with regard to the Figures 3, 6, 7 and 8, it has to be mentioned that at least these solutions of an optical transmitter are such, in which the second mirror M2 is optically coupled to the first filter OF1.

To summarize the different solutions for an optical transmitter OLT1, OLT2, OLT3, OLT4 as described with regard to the Figures 3, 6, 7 and 8, it has to be mentioned that at least these solutions of an optical transmitter are such, in which the first filter is a cyclic arrayed waveguide grating AWG.

To summarize the different solutions for an optical transmitter OLT1, OLT2, OLT3, OLT4 as described with regard to the Figures 3, 6, 7 and 8, it has to be mentioned that at least these solutions of an optical transmitter are such, in which wherein the cyclic arrayed waveguide grating AWG comprises a number of amplifier sided ports AP1, ..., APn, one AP1 of which is connected to the optical amplifier SOA, and two network sided ports NP0, NP1, wherein the second optical filter is connected to one of the network sided ports NP0 and wherein the second mirror M2 is connected to the other of the network sided ports NP1, and wherein the cyclic arrayed waveguide grating AWG is configured such that a first and a second diffraction orders of an optical signal at a wavelength entering the cyclic arrayed waveguide grating AWG at one of the amplifier sided ports AP1, ..., APn are focused at one of the network sided ports NP0 and the other of the network sided ports NP1 respectively.

To summarize the different solutions for an optical transmitter ONU1, ONU2, ONU3, ONU4, RN as described with regard to the Figures 9, 11, 13 and 14, it has to be mentioned that at least these solutions of an optical transmitter are such, in which the second filter OF12, OF222, COF is a cyclic wavelength multiplexer / demultiplexer, and wherein the first filter OF111, OF13, COF is a passband filter.

To summarize the different solutions for an optical transmitter ONU1, ONU2, RN as described with regard to the Figures 9 and 11, it has to be mentioned that at least these solutions of an optical transmitter are such, in which the second mirror M2 is optically coupled to the second filter OF12, OF222, COF.

To summarize the different solutions for an optical transmitter ONU2, RN as described with regard to the Figure 11, it has to be mentioned that at least this solution of an optical transmitter is such, in which the second filter OF222 is a cyclic arrayed waveguide grating AWG with a free spectral range corresponding to a bandwidth distance of a downstream bandwidth B2 and an upstream bandwidth B1.

To summarize the different solutions for an optical transmitter ONU1, ONU2, ONU3, ONU4, RN as described with regard to the Figures 9, 11, 13 and 14, it has to be mentioned that at least these solutions of an optical transmitter are such, in which the second filter OF222, COF is a cyclic wavelength multiplexer / demultiplexer, and wherein the first filter OF13, COF is a tunable passband filter.

To summarize the different solutions for an optical transmitter ONU1, ONU2, RN as described with regard to the Figures 9 and 11, it has to be mentioned that at least these solutions of an optical transmitter are such, in which the optical transmitter comprised an optical network unit and a remote node RN for an optical access network.

## Claims

1. Optical transmitter (OLT1, OLT2, OLT3) for an optical network, comprising
- a first mirror (M1) and a second mirror (M2),
- a semiconductor optical amplifier (SOA),
- a first optical filter (OF1, OF11) and a second optical filter (OF2, OF22),
wherein said first optical filter (OF1, OF11) and said second optical filter (OF2, OF22) are in series connection to each other,
wherein said first mirror (M1) is located, such that a first fraction of an optical signal emitted by said semiconductor optical amplifier (SOA) is reflected back to said semiconductor optical amplifier (SOA),
wherein a second fraction of an optical signal emitted by said semiconductor optical amplifier (SOA) is transmitted towards said series connection of said optical filters, **characterized in that**
- said first optical filter (OF1, OF11) is a cyclic Arrayed Waveguide Grating (AWG) containing a number of amplifier-sided ports (AP1, ..., APn) to which respective semiconductor optical amplifiers may be connected,
- said second optical filter (OF2, OF22) is a non-cyclic AWG containing a number of incoming ports (P1, ... , Pn),
- said SOA is connected indirectly via said first filter to one of said incoming ports (P1) of said second optical filter (OF2, OF22),
and **in that** said second mirror (M2) is optically coupled to said first or said second filter, such that said first and said second mirror (M1, M2) delimit a cavity, which comprises said semiconductor optical amplifier (SOA) and at least one of said optical filters and which is adapted to generate a coherent optical signal.

2. Optical transmitter (OLT1, OLT2, OLT3) according to claim 1,
wherein said optical filters are wavelength dependent passband filters, and wherein the passband transfer functions of said optical filters acting on said optical signal determine that wavelength, at which an optical signal is transmitted by said optical transmitter.

3. Optical transmitter (OLT1, OLT2, OLT3) according to claim 1,
wherein said first optical filter is a cyclic wavelength multiplexer/demultiplexer with a free spectral range smaller than a downstream transmission bandwidth (B2),
wherein said second optical filter is a wavelength multiplexer/demultiplexer in the form of a non-cyclic AWG.

4. Optical transmitter (OLT1, OLT2, OLT3) according to claim 3,
wherein said second mirror (M2) is optically coupled to said first filter (OF1).

5. Optical transmitter (OLT1, OLT2, OLT3) according to claim 4,
wherein said cyclic arrayed waveguide grating (AWG) comprises a number of amplifier sided ports (AP1, ..., APn), one (AP1) of which is connected to said optical amplifier (SOA), and two network sided ports (NP0, NP1), wherein said second optical filter is connected to one of said network sided ports (NPO) and wherein said second mirror (M2) is connected to the other of said network sided ports (NP1),
and wherein said cyclic arrayed waveguide grating (AWG) is configured such that a first and a second diffraction orders of an optical signal at a wavelength entering said cyclic arrayed waveguide grating (AWG) at one of said amplifier sided ports (AP1, ..., APn) are focused at one of said network sided ports (NPO) and the other of said network sided ports (NP1) respectively.

6. Optical transmitter (OLT1, OLT2, OLT3) for an optical network according to claim 1,
wherein said optical network is an optical access network.

7. Optical transmitter (OLT1, OLT2, OLT3) according to claim 3,
wherein said optical transmitter is an optical line terminal for an optical access network.

## Patentansprüche

1. Optischer Sender (OLT1, OLT2, OLT3) für ein optisches Netzwerk, umfassend
- einen ersten Spiegel (M1) und einen zweiten Spiegel (M2),
- einen Halbleiterlaserverstärker (SOA),
- einen ersten optischen Filter (OF1, OF1 1) und einen zweiten optischen Filter (OF2, OF22),
wobei der besagte erste optische Filter (OF1, OF11) und der besagte zweite optische Filter (OF2, OF22) in Reihe miteinander verschaltet sind,
wobei der besagte erste Spiegel (M1) so angeordnet ist, dass ein erster Bruchteil eines optischen Signals, das von dem besagten Halbleiterlaserverstärker (SOA) ausgesendet wird, zu dem besagten Halbleiterlaserverstärker (SOA) zurückreflektiert wird,
wobei ein zweiter Bruchteil eines optischen Signals, das von dem besagten Halbleiterlaserverstärker (SOA) ausgesendet wird, zu der besagten Reihenschaltung der besagten optischen Filter gesendet wird,
**dadurch gekennzeichnet, dass**
- der besagte erste optische Filter (OF1, OF11) ein zyklisches angeordnetes Wellenleitergitter (AWG) ist, das eine Anzahl von verstärkerseitigen Ports (AP1, ..., APn) enthält, an die jeweilige Halbleiterlaserverstärker angeschlossen werden können,
- der besagte zweite optische Filter (OF2, OF22) ein nicht-zyklisches AWG ist, das eine Anzahl von eingehenden Ports (P1, ..., Pn) enthält,
- der besagte SOA über den besagten ersten Filter indirekt an einen der besagten eingehenden Ports (P1) des besagten zweiten optischen Filters (OF2, OF22) angeschlossen ist,
und dadurch, dass der besagte zweite Spiegel (M2) optisch an den besagten ersten oder den besagten zweiten Filter gekoppelt ist, so dass der besagte erste und der besagte zweite Spiegel (M1, M2) einen Hohlraum begrenzen, der den besagten Halbleiterlaserverstärker (SOA) und mindestens einen der besagten optischen Filter umfasst und der angepasst ist, um ein kohärentes optisches Signal zu erzeugen.

2. Optischer Sender (OLT1, OLT2, OLT3) nach Anspruch 1,
wobei die besagten optischen Filter wellenlängenabhängige Durchlassbereichsfilter sind, und wobei die Durchlassbereich-Übertragungsfunktionen der besagten optischen Filter, die auf das besagte optische Signal wirken, jene Wellenlänge bestimmen, bei der ein optisches Signal von dem besagten optischen Sender gesendet wird.

3. Optischer Sender (OLT1, OLT2, OLT3) nach Anspruch 1,
wobei der besagte erste optische Filter ein zyklischer Wellenlängen-Multiplexer/Demultiplexer mit einem freien Spektralbereich ist, der kleiner ist als eine nachgelagerte Übertragungsbandbreite (B2),
wobei der besagte zweite optische Filter ein Wellenlängen-Multiplexer/Demultiplexer in Form eines nicht-zyklischen AWGs ist.

4. Optischer Sender (OLT1, OLT2, OLT3) nach Anspruch 3,
wobei der besagte zweite Spiegel (M2) optisch an den besagten ersten Filter (OF1) gekoppelt ist.

5. Optischer Sender (OLT1, OLT2, OLT3) nach Anspruch 4,
wobei das besagte zyklische angeordnete Wellenleitergitter (AWG) eine Anzahl von verstärkerseitigen Ports (AP1, ..., APn) umfasst, von denen einer (AP1) an den besagten Halbleiterlaserverstärker (SOA) angeschlossen ist, und zwei netzwerkseitige Ports (NP0, NP1), wobei der besagte zweite optische Filter an einen der besagten netzwerkseitigen Ports (NPO) angeschlossen ist und wobei der besagte zweite Spiegel (M2) an den anderen der besagten netzwerkseitigen Ports (NP1) angeschlossen ist,
und wobei das besagte zyklische angeordnete Wellenleitergitter (AWG) so ausgelegt ist, dass eine erste und eine zweite Beugungsordnung eines optischen Signals einer Wellenlänge, das in das besagte zyklische angeordnete Wellenleitergitter (AWG) an einem der besagten verstärkerseitigen Ports (AP1, ..., APn) eingeht, jeweils an einem der besagten netzwerkseitigen Ports (NPO) und dem anderen der besagten netzwerkseitigen Ports (NP1) fokussiert werden.

6. Optischer Sender (OLT1, OLT2, OLT3) für ein optisches Netzwerk nach Anspruch 1,
wobei das besagte optische Netzwerk ein optisches Zugangsnetzwerk ist.

7. Optischer Sender (OLT1, OLT2, OLT3) nach Anspruch 3,
wobei der besagte optische Sender ein optisches Leitungsendgerät für ein optisches Zugangsnetzwerk ist.

## Revendications

1. Émetteur optique (OLT1, OLT2, OLT3) pour un réseau optique, comprenant
- un premier miroir (M1) et un deuxième miroir (M2),
- un amplificateur optique à semi-conducteur (SOA),
- un premier filtre optique (OF1, OF11) et un deuxième filtre optique (OF2, OF22), dans lequel ledit premier filtre optique (OF1, OF11) et ledit deuxième filtre optique (OF2, OF22) sont connectés en série entre eux,
dans lequel ledit premier miroir (M1) est situé de sorte qu'une première fraction d'un signal optique émis par ledit amplificateur optique à semi-conducteur (SOA) soit renvoyée audit amplificateur optique à semi-conducteur (SOA),
dans lequel une deuxième fraction d'un signal optique émis par ledit amplificateur optique à semi-conducteur (SOA) est transmise par l'intermédiaire de ladite connexion en série desdits filtres optiques, **caractérisé en ce que**
- ledit premier filtre optique (OF1, OF11) est un réseau sélectif planaire (AWG) cyclique contenant un certain nombre de ports côté amplificateur (AP1, ..., APn) auxquels des amplificateurs optiques à semi-conducteur respectifs peuvent être connectés,
- ledit deuxième filtre optique (OF2, OF22) est un AWG non cyclique contenant un certain nombre de ports entrants (P1, ..., Pn),
- ledit SOA est connecté indirectement par l'intermédiaire dudit premier filtre à un desdits ports entrants (P1) dudit deuxième filtre optique (OF2, OF22),
et **en ce que** ledit deuxième miroir (M2) est couplé optiquement audit premier filtre ou audit deuxième filtre, de sorte que ledit premier et ledit deuxième miroirs (M1, M2) délimitent une cavité, qui comprend ledit amplificateur optique à semi-conducteur (SOA) et au moins un desdits filtres optiques et qui est adapté pour générer un signal optique cohérent.

2. Émetteur optique (OLT1, OLT2, OLT3) selon la revendication 1,
dans lequel lesdits filtres optiques sont des filtres passe-bande dépendant de la longueur d'onde, et dans lequel les fonctions de transfert passe-bande desdits filtres optiques agissant sur ledit signal optique déterminent cette longueur d'onde, à laquelle un signal optique est transmis par ledit émetteur optique.

3. Émetteur optique (OLT1, OLT2, OLT3) selon la revendication 1,
dans lequel ledit premier filtre optique est un multiplexeur/démultiplexeur en longueur d'onde cyclique avec une plage spectrale libre inférieure à une largeur de bande de transmission aval (B2),
dans lequel ledit deuxième filtre optique est un multiplexeur/démultiplexeur en longueur d'onde sous la forme d'un AWG non cyclique.

4. Émetteur optique (OLT1, OLT2, OLT3) selon la revendication 3,
dans lequel ledit deuxième miroir (M2) est couplé optiquement audit premier filtre (OF1).

5. Émetteur optique (OLT1, OLT2, OLT3) selon la revendication 4,
dans lequel ledit réseau sélectif planaire (AWG) cyclique comprend un certain nombre de ports côté amplificateur (AP1, ..., APn), un (AP1) d'entre eux étant connecté audit amplificateur optique (SOA), et deux ports côté réseau (NP0, NP1), dans lequel ledit deuxième filtre optique est connecté à un desdits ports côté réseau (NPO) et dans lequel ledit deuxième miroir (M2) est connecté à l'autre port parmi lesdits ports côté réseau (NP1),
et dans lequel ledit réseau sélectif planaire (AWG) cyclique est configuré de sorte qu'un premier et un deuxième ordres de diffraction d'un signal optique à une longueur d'onde entrant dans ledit réseau sélectif planaire (AWG) cyclique au niveau d'un desdits ports côté amplificateur (AP1, ..., APn) soient focalisés au niveau d'un desdits ports côté réseau (NPO) et au niveau de l'autre port parmi lesdits ports côté réseau (NP1) respectivement.

6. Émetteur optique (OLT1, OLT2, OLT3) pour un réseau optique selon la revendication 1,
dans lequel ledit réseau optique est un réseau d'accès optique.

7. Émetteur optique (OLT1, OLT2, OLT3) selon la revendication 3,
dans lequel ledit émetteur optique est un terminal de ligne optique pour un réseau d'accès optique.
